Europäisches Patentamt

European Patent Office

Office européen des brevets

(11) Publication number: 0 298 628
A2

## (12) EUROPEAN PATENT APPLICATION

(21) Application number: 88305698.8

(22) Date of filing: 22.06.88

(51) Int. Cl.⁴ H01L 29/28 , H01L 29/78 , H01L 29/62 , H01L 29/60

(30) Priority: 07.07.87 GB 8715959

(43) Date of publication of application:
11.01.89 Bulletin 89/02

(84) Designated Contracting States:
AT BE CH DE FR GB GR IT LI NL SE

(71) Applicant: The British Petroleum Company p.l.c.
Britannic House Moor Lane
London EC2Y 9BU(GB)

(72) Inventor: Allen, Philip Charles
3 Denison Road
Feltham Middlesex TW13 4PY(GB)
Inventor: Friend, Richard Henry
6 Sherlock Road
Cambridge CB3 0HR(GB)
Inventor: Burroughes, Jeremy Henly
39 Great Eastern Street
Cambridge CB1 3AB(GB)

(74) Representative: Krishnan, Suryanarayana Kalayana et al
BP INTERNATIONAL LIMITED Patents & Agreements Division Chertsey Road
Sunbury-on-Thames Middlesex TW16 7LN(GB)

(54) Field effect transistors.

(57) This invention relates to a field effect transistor (FET) which has a gate electrode deposited on a substrate and separated from a semiconducting layer by an insulating layer, the semiconducting layer being provided with two terminals to allow passage of an electric current. The inventive feature lies in the use of a coherent, conducting organic polymer selected from poly(acetylene), poly(thienylene vinylene), poly(furanylene vinylene) and substituted derivatives thereof as the semiconducting layer.

FIG.1

Polymer F.E.T structure.

## FIELD EFFECT TRANSISTORS

The present invention relates to metal-insulator-semiconductor field effect transistors (MISFET's) in which organic polymers are used as the semiconducting component.

FET's are devices exhibiting modulation of conductivity by the field effect i.e. an electric field is used to control the flow of current through a system. Basically MISFET's comprise a conductive gate electrode separated from a semiconductor layer by an insulating layer. The semiconductor layer is contacted by two electrodes known as the source and drain. Electric currents are passed through the semiconductor layer via the source and drain electrodes. The field at the semiconductor/insulator interface produces a surface charge layer in the semiconductor, and source-drain conduction is enhanced when these charges are mobile. Dependent on the direction of the field, the surface charge layer is composed of charges with the same sign as the majority carriers in the bulk semiconductor (accumulationlayer) or the opposite sign (inversion layer).

Such a system is usually formed or mounted on a supporting substrate.

The FET's hitherto used have a planar configuration and use a metalloid such as amorphous silicon or crystalline silicon as the semiconductor. These suffer from the disadvantage that their deposition involves complex and expensive technologies. Furthermore, the films are not easily produced in other than a planar format generally restricting their use to planar devices. Similar problems exist with some organic polymers which cannot be produced in coherent form, especially coherent film form.

It has now been found that the problems associated with inorganic semiconductors can be mitigated by using specific organic polymers.

Accordingly, the present invention is a field effect transistor (FET) comprising a gate electrode deposited on a substrate and separated from a semiconducting layer by an insulating layer, the semiconducting layer being provided with at least two terminals to allow the passage of an electric current characterised in that the semiconducting is of a coherent conducting organic polymer selected from poly(acetylene), poly(thienylene vinylene), poly(furanylene vinylene) and substituted derivatives thereof.

By coherent is meant here and throughout the specification that such polymers, especially in film form are free from voids at magnifications of up to 5000 when observed under an SEM microscope.

The gate is preferably highly conductive and may be for instance of steel, copper, gold, platinum, aluminium, indium-tin-oxide or heavily doped silicon. The FET suitably has a substrate such as quartz, glass or silicon. Where a silicon substrate is used, it may be heavily doped at the surface thereby enabling it to act both as the gate electrode and the substrate. Where the substrate used is e.g. quartz or glass, it is essential to deposit the gate electrode thereon.

The insulating layer may be provided by any insulator with good dielectric properties known to those skilled in the art. Suitable examples of insulators include silicon dioxide, silicon nitride, or polymers having good insulating properties.

The insulator is preferably used as a relatively thin layer e.g. up to 5000 Å.

The terminals allowing current to pass through the device are the source and the drain contacts and these are formed e.g. by evaporating or otherwise coating metals or conductors onto the substrate. The choice of the metal or conductor used for these contacts will determine whether injection of either positive or negative charges into the surface charge layer is preferred. Examples of these include platinum, gold, aluminium, copper, indium-tin oxide, heavily-doped silicon and the like. The source and drain contacts may be formed before or after a layer of conducting polymer is formed on the insulator. The source and drain contacts are preferably formed on the insulator before a layer of the conducting polymer is deposited. If the source and drain contacts are formed onto the layer of conducting polymer, the method used should be such that the conducting polymer is not adversely affected with respect to its structure or properties.

The coherent polymer is selected from poly(acetylene), poly(thienylene vinylene) poly(furanylene vinylene) and substituted derivatives thereof. The substituents may be H, $C_1$-$C_4$ alkyl, $C_1$-$C_4$ haloalkyl, and a group derivable from an ester of a $C_1$-$C_4$ carboxylic acid. -H,-$CH_3$,-$C_2H_5$,-$CF_3$ and -$COOCH_3$ groups are preferred. Methods of preparing poly(acetylene) are claimed and described in our published EP-A-80329 whereas method of preparing poly(thienylene vinylene) and poly(furanylene vinylene) are claimed and described in our published EP-A-182548. The conducting polymers used may or may not contain dopants such as iodine, arsenic pentafluoride, perchlorates and the like. The dopants enable the semiconducting characteristics of the conducting polymer to be controlled as desired by varying the dopant used and the concentration of a chosen dopant in a given organic polymer.

The conducting organic polymers are suitably used as a thin film, typically up to 4000 Å. Poly-

(acetylene) is the preferred organic polymer.

A feature of the present invention is that the layer of conducting organic polymer can be deposited as the final step in the fabrication of an FET device. In this method of fabrication, the sequence of layers is that of the substrate followed by the gate electrode, then the insulating layer upon which are formed the source and drain contacts and finally the layer of conducting polymer. The principal advantage of this method is that it enables the expensive fabrication steps of the FET device to be thoroughly checked before the conducting polymer layer is put on top. This also has the advantage that the sensitive polymer layer is not exposed to chemicals or high temperatures. Thus, the formation of the device follows a sequence which is the reverse of that normally used with conventional silicon semiconductors.

The FET's according to the present invention are preferably the conventional planar types but may be of non-planar or irregular shape. The use of an organic polymer as the semiconductor enables the film of said polymer to be applied to non-planar or irregular configurations. Thus, for instance, the FET may be of a concentric cylindrical shape with the core forming the gate which is separated from the outermost semiconducting layer by an intervening cylinder of an insulator. The source and drain contacts in this case can be arranged around the periphery of the device. Moreover, the FET's of the present invention lend themselves to the formation of matrices comprising several such devices arranged in an array, each device having its own source and drain terminals.

In the FET devices, each of the terminals i.e. the source and the drain and the gate is suitably about 2000 Å in thickness. The insulating layer has a thickness of 500-2000 Å and the conducting polymer layer is typically 3300 Å thick.

The FET's of the present invention may be employed in all the conventional uses to which similar silicon FET's are put e.g. switching systems.

The invention is now further illustrated with reference to the accompanying drawing which is a transverse section through the channel region of a typical FET according to the present invention.

Example 1

An insulating layer (3) of silicon dioxide was formed on the top surface of a heavily doped (n-type) disc of silicon which formed a combined gate terminal (2) and substrate layer (1). Two terminals forming the source (5) and drain (6) contacts were then evaporated on top of the insulating layer (3). These contacts were formed by a layer of titanium 0.02 micron thick followed by a layer of gold 0.2 micron thick. Subsequently a semiconducting layer (4) of 0.33 micron thickness was formed with poly-(acetylene) on top of the insulating layer (3) of silicon dioxide and the source (5) and drain (6). The active region of this FET was of 6 micron thickness and extended for 250 microns thickness in the plane of the device.

With a drain-source voltage ($V_{DS}$) of $+50$ V, the drain-source current ($I_{DS}$) was dependent on the gate-source voltage ($V_{GS}$) in the following manner:-

$V_{GS}$ -50 V     $I_{DS}$ $3.7 \times 10^{-7}$ A
-30 V     $2.7 \times 10^{-7}$ A
-10 V     $1.6 \times 10^{-7}$ A
0 V     $1.3 \times 10^{-7}$ A
+20 V     $0.9 \times 10^{-7}$ A
+50 V     $0.7 \times 10^{-7}$ A

- showing modulation of the channel current by application of a gate voltage.

Example 2

The FET substrate was a heavily phosphorous doped ($10^{19}$ cm$^{-3}$) silicon disc (1) onto which 2000Å of silicon dioxide (3) was thermally grown. The doped silicon substrate acted as a distributed gate electrode for the FET structure. The source (5) and drain (6) contacts were formed from evaporated gold. The gold thickness was 500Å. The channel length and effective width of the FET structure was 0.1mm and 75mm respectively. Finally, polyacetylene precursor solution was spin-coated at 2000 r.p.m. for 60 seconds onto the substrate. The concentration of the solution was 1 gram of dried precursor to 100 ml 2-butanone. Thermal conversion to trans-polyacetylene was achieved by heating at 80°C for 12 hours. The polyacetylene film thickness after fully isomerizing the polymer was estimated to be 200Å.

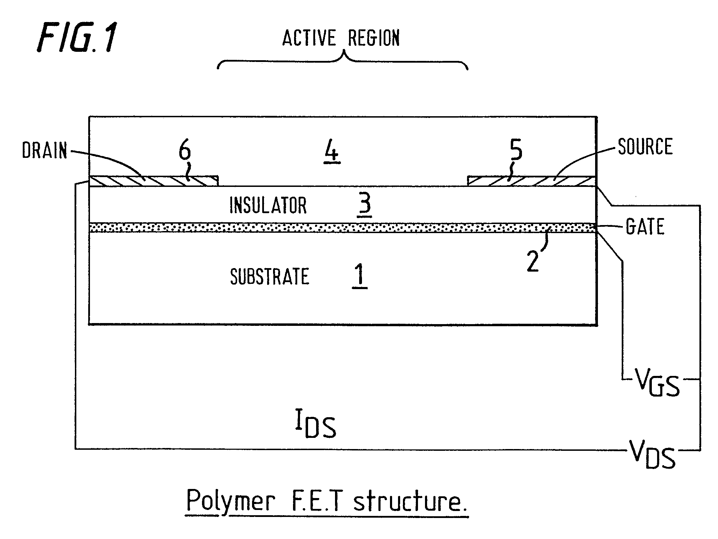

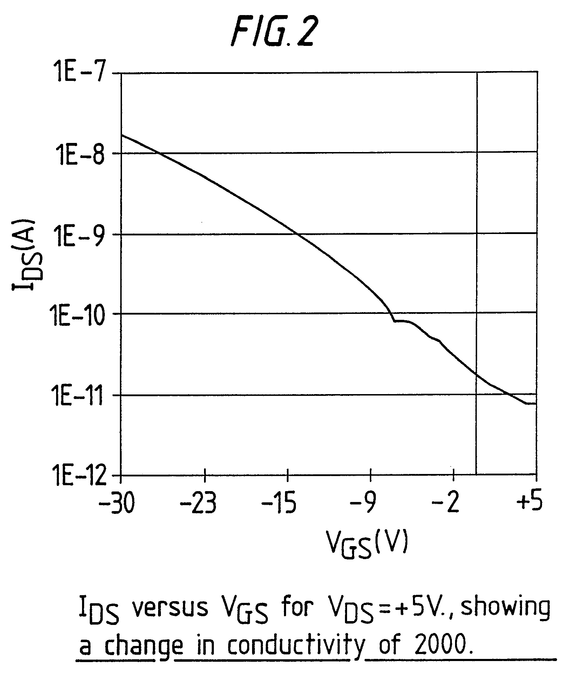

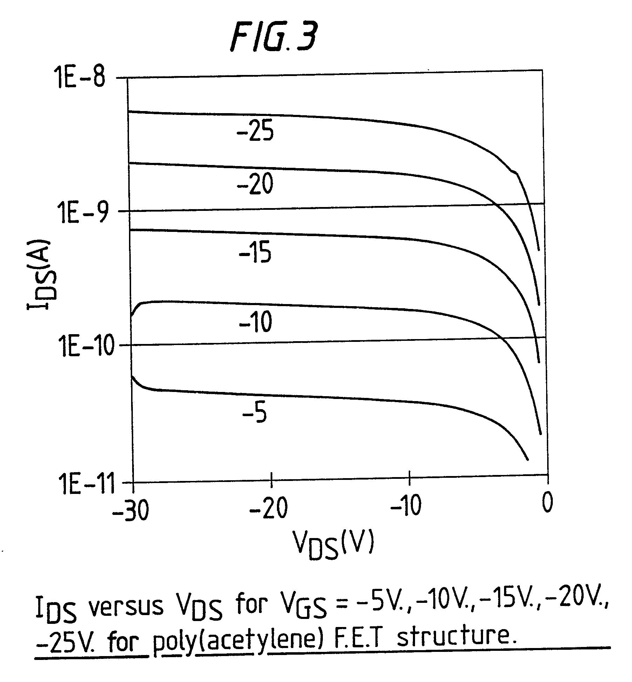

The electrical characteristics of this FET structure are displayed in Figures 2 and 3. Figure 2 shows the source/drain current ($I_{DS}$) versus the gate voltage ($V_{GS}$) for a source/drain voltage ($V_{DS}$) of $+5$V. The change in the channel conductivity between $V_{GS}$) = 5 and -30V is 2000. Figure 3 shows $I_{DS}$ versus $V_{DS}$ for constant $V_{GS}$. The threshold voltage for this device was at 0V.

Example 3

The FET substrate was an ultra-pure ($< 10^{13}$ cm$^{-3}$ charge carriers) silicon disc (1) onto which 2000Å of silicon dioxide (3) was thermally grown. At the silicon/silicon dioxide interface the silicon was heavily phosphorous doped ($10^{19}$ cm$^{-3}$) to a depth 4000Å. The doped silicon region acted as a distributed gate electrode for the FET structure. The source and drain contacts were formed from glow discharged poly-silicon which was then heavily phosphorous doped. The poly-n-silicon thickness was 4000Å. On top of the poly-n-silicon source/drain contacts was evaporated 500Å of aluminium. The channel length and the effective width of the FET structure was 0.02 mm and 1.5m respectively. The polyacetylene film was formed from precursor solution which was spin-coated at 2000 r.p.m. for 60 seconds onto the substrate. The concentration of the solution was 1 gram of dried precursor to 100 ml 2-butanone. Thermal conversion to trans-polyacetylene was achieved by heating at 80°C for 12 hours. The polyacetylene film thickness after fully isomerizing the polymer was estimated to be 200Å.

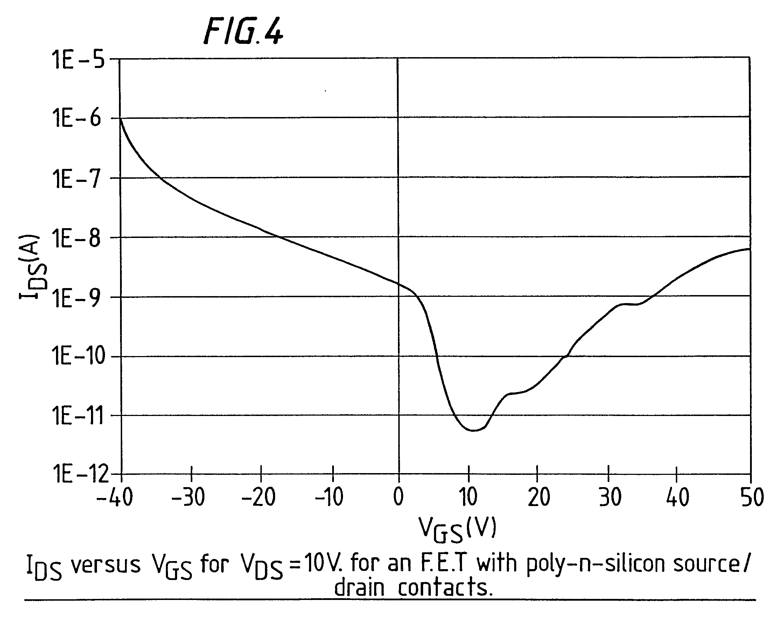

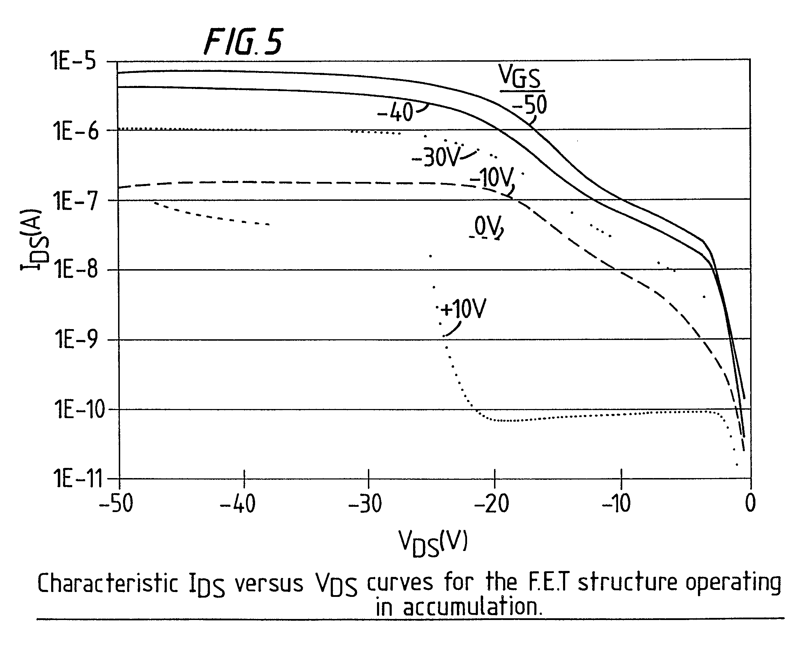

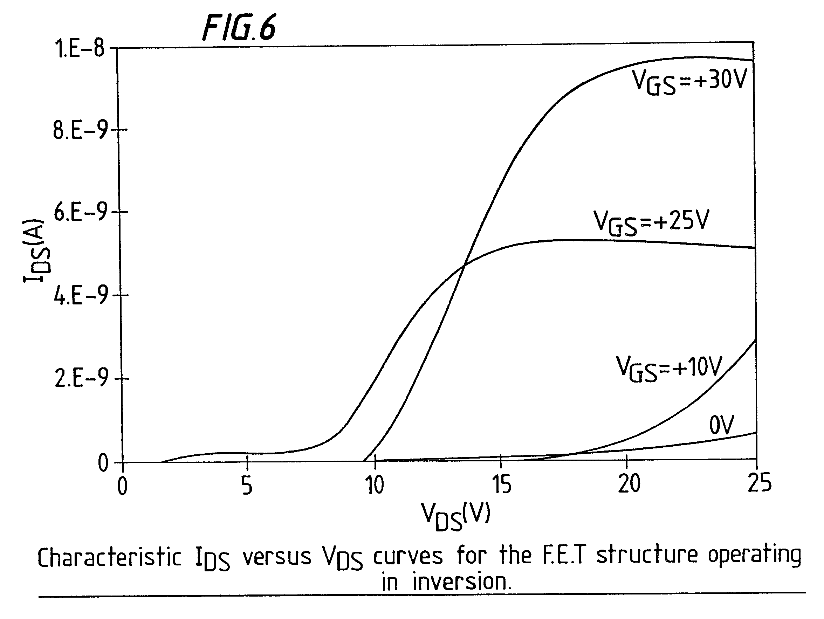

The channel conductivity between the source and drain contacts was found to be dependent on the gate voltage. Figure 4 shows $I_{DS}$ versus $V_{GS}$ for $V_{DS}$ = 10V. The data shows that the conductivity of the channel has a minimum at $V_{GS}$ = 10V, and increases for $V_{GS}$ less than and greater than 10V. The large channel conductivity for negative gate voltages is due to the formation of a mobile majority change carrier layer at the silicon dioxide/polyacetylene interface (i.e. accumulation) and for large positive gate voltages is due to the formation of a mobile minority charge carrier layer (i.e. inversion) at this interface. On/off current ratio for the accumulation layer was 100,000 and for the inversion layer was 1000. The FET characteristics for the structure working in both accumulation and inversion are shown in Figures 5 and 6. Both Figures are plots of $I_{DS}$ versus $V_{DS}$ for constant gate voltages. The threshold voltage for this FET structure was -23V.

## Claims

1. A field effect transistor (FET) comprising a gate electrode deposited on a substrate and separated from a semiconducting layer by an insulating layer, the semiconducting layer being provided with at least two terminals to allow passage of an electric current characterised in that the semiconducting layer is of a coherent, conducting organic polymer selected from poly(acetylene), poly(thienylene vinylene), poly(furanylene vinylene) and substituted derivatives thereof.

2. An FET according to claim 1 wherein the gate electrode is of steel, copper, gold, platinum, aluminium, indium-tin oxide or heavily doped silicon.

3. An FET according to claims 1 or 2 wherein the insulating layer is of silicon dioxide, silicon nitride or of polymers having good insulating properties.

4. An FET according to any one of the preceding claims wherein the insulating layer has a thickness of up to 5000Å.

5. An FET according to any one of the preceding claims wherein the two terminals are the source and drain contacts.

6. An FET according to any one of the preceding claims wherein the substrate is of quartz, glass or silicon.

7. An FET according to any one of the preceding claims wherein the substrate is of silicon which is heavily doped on the surface adjacent to the insulating layer, the doped surface acting as the gate electrode.

8. An FET according to any one of the preceding claims wherein the conducting polymer forming the semiconducting layer is doped with a dopant.

9. An FET according to any one of the preceding claims wherein the conducting polymer is used as a film having a thickness up to 4000Å.

10. An FET according to claim 5 in which the conductance of the source-drain contacts is enhanced by the application of either positive or negative gate voltages.

11. A process for the fabrication of a device which is an FET claimed in any one of the preceding claims 1-6, said process comprising depositing in sequence on a substrate layer, a gate electrode, followed by an insulating layer upon which are formed the source and drain contacts and finally a layer of a conducting polymer acting as the semiconducting layer.

12. A process for the fabrication of a device which is an FET according to claim 11 wherein the substrate is silicon which is heavily doped on its surface adjacent to the insulating layer and thereby acts as the gate electrode.

FIG.1

ACTIVE REGION

DRAIN

6     4     5     SOURCE

INSULATOR   3

GATE

2

SUBSTRATE   1

$I_{DS}$

$V_{GS}$

$V_{DS}$

Polymer F.E.T structure.

EP 0 298 628 A2

## FIG.2

$I_{DS}$ versus $V_{GS}$ for $V_{DS} = +5V.$, showing a change in conductivity of 2000.

FIG.3

$I_{DS}$ versus $V_{DS}$ for $V_{GS}$ = -5V., -10V., -15V., -20V., -25V. for poly(acetylene) F.E.T structure.

**FIG.4**

$I_{DS}$ versus $V_{GS}$ for $V_{DS} = 10V$. for an F.E.T with poly-n-silicon source/ drain contacts.

EP 0 298 628 A2

**FIG.5**

Characteristic $I_{DS}$ versus $V_{DS}$ curves for the F.E.T structure operating in accumulation.

EP 0 298 628 A2

**FIG.6**

Characteristic $I_{DS}$ versus $V_{DS}$ curves for the F.E.T structure operating in inversion.

EP 0 298 628 A2